# EUROPEAN PATENT SPECIFICATION

(11) **EP 1 996 003 B1**
(45) Date of publication and mention of the grant of the patent: **24.08.2011**
(21) Application number: 08155822.3
(22) Date of filing: 07.05.2008
(51) Int. Cl.: H05K 3/36

(54) **Flexible Print Circuit And Liquid Crystal Display Device**
Flexible gedruckte Schaltung und Flüssigkristallanzeigevorrichtung
Circuit d'impression flexible et dispositif d'affichage à cristaux liquides

(30) Priority: 23.05.2007 JP 2007136297
(43) Date of publication of application: 26.11.2008
(73) Proprietor: Funai Electric Co., Ltd., Daito-shi Osaka 574-0013 (JP)
(72) Inventor: Sakikubo, Takayuki, Osaka 574-0013 (JP)
(74) Representative: Beetz & Partner

(56) References cited:
- EP-A- 1 544 948
- JP-A- 11 121 894
- US-A1- 2004 106 306
- US-A1- 2005 258 153
- US-A1- 2006 067 066
- US-A1- 2007 169 136

## Description

### BACKGROUND OF THE INVENTION

### Field of the Invention

The present invention relates to a flexible print circuit, and in particular, the present invention relates to structure of a flexible print circuit which is used in bonded with other flexible print circuit. Further, the present invention relates to a liquid crystal display device which is provided with such flexible print circuit.

### Description of Related Art

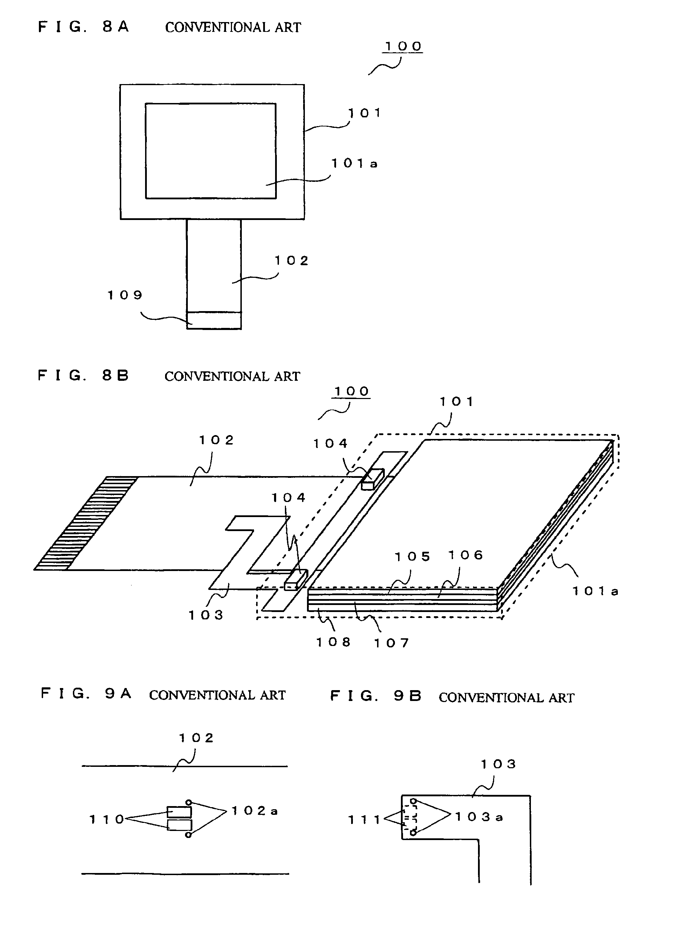

Heretofore, two flexible print circuits (FPCs) have been positioned to be bonded. As one example of positioning two FPCs to be bonded, a liquid crystal display device will be explained by way of example. Fig. 8A and Fig. 8B are diagrams to show structure of a conventional liquid crystal display device, Fig. 8A is a schematic plan view of a liquid crystal display device when viewed from a front side, and Fig. 8B is a schematic perspective view of a liquid crystal display device when viewed from a back side in an oblique direction.

As shown in Fig. 8A and Fig. 8B, the conventional liquid crystal display device 100 is provided with a liquid crystal display portion 101 which has a liquid crystal display surface 101a, a first FPC 102 which connects the liquid crystal display portion 101 with an external connector that is not shown, and a second FPC 103 which is set up to branch a part of wirings formed in the first FPC 102 and which is different from the first FPC 102. The liquid crystal display portion 101 is provided with back light sources 104, a reflection sheet 105, a light guide plate 106, an optical sheet 107, and a liquid crystal panel 108 as shown in Fig. 8B.

The back light sources 104 is composed of a plurality of light emission diodes (LEDs), and light which is emitted from the light sources 104 is input to a side surface of the light guide plate 106 directly or after it is reflected by a reflector that is not shown. The light guide plate 106 propagates the input light with making it reflect in its body, and outputs the light from a surface which faces to the optical sheet 107, or a surface which faces to the reflection sheet 105. It should be noted that the light which is output from the surface that faces to the reflection sheet 105, is input to the light guide plate 106 again because it is reflected by the reflection sheet 105.

The optical sheet 107 is formed of a diffusion sheet or a lens sheet, and it guides the light which is output from the surface of the light guide plate 106 that faces to the optical sheet 107, to the liquid crystal panel 108 with performing correction of uneven brightness and the like. The liquid crystal panel 108 has structure in that liquid crystal is enclosed between two panel plates, though it is not shown in the drawing. Further, on a surface of the panel plate in a side which the liquid crystal is enclosed, an electrode is disposed in a matrix shape to enable controlling of the liquid crystal though it is not shown in the drawing.

On the first FPC 102, wirings to drive the back light sources 104 and the liquid crystal panel 108 are formed, and one ends of these wirings (in a side where a reinforcing plate 109 is set up) are connected to an external connector though it is not shown in the drawing. The other ends of the wirings which are formed in the first FPC 102 to drive the back light sources 104, are connected to first electrode pads (though they are not shown in Fig. 8B, they are shown with reference numeral 110 in Fig. 9A that will be described later) which are formed in the first FPC 102. On the other hand, the other ends of the wirings which are formed in the first FPC 102 to drive the liquid crystal panel 108, are connected finally to an electrode which is formed in the liquid crystal panel 108.

The first electrode pads 110 which are formed in the first FPC 102, are bonded, for example, utilizing solder to second electrode pads (though they are not shown in Fig. 8B, they are shown with reference numeral 111 in Fig. 9B that will be described later) which are formed in the second FPC 103 that has wirings connected finally to the back light sources 104. According to this arrangement, the back light sources 104 are connected to the external connector via the wirings which are formed in the second FPC 103 and the first FPC 102.

As above described, in the liquid crystal display device 100, two FPCs 102, 103 are bonded. Because two FPCs 102, 103 which have flexibility are bonded, misalignment of position tends to be generated when the two FPCs 102, 103 are bonded, and it causes a problem of workability. To avoid this problem, positioning holes 102a, 103a are respectively set up on the two FPCs 102, 103 as shown in Fig. 9A and Fig. 9B, and bonding of the two FPCs 102, 103 were performed by putting pins in the positioning holes 102a, 103a to fix in the conventional FPC.

Fig. 9A and Fig. 9B are diagrams to explain structure of the two FPCs 102, 103 which are included in the conventional liquid crystal display device 100, Fig. 9A is a diagram to show circumference of the first electrode pads 110 of the first FPC 102 on which wirings to drive the back light sources 104 and the liquid crystal panel 108 are formed, and Fig. 9B is a diagram to show circumference of the second electrode pads 111 of the second FPC 103 on which wirings to drive the back light sources 104 are formed. In Fig. 9B, the reason why the second electrode pads 111 are shown by dotted line, is it means that the second electrode pads 111 are located in reverse surface of the FPC.

However, in case of the above described method, because it becomes necessary to set up the holes, large spaces for the FPCs 102, 103 are required, and it causes problems of the increase of the device size, and increase of production cost. To avoid these problems, with considering that precise accuracy is not required for positioning the two FPCs 102, 103, a marker is formed by silk printing on the first FPC 102 side, and positioning of the two FPCs 102, 103 is performed. In case of such method, because large space is not necessary in comparison with the case to open the holes, the problem of increasing spaces of the FPCs 102, 103 can be solved.

However, in the case where the silk printing is performed, it is not preferable that it causes increase of production cost because material which is not used in the past, is required and additional material cost becomes necessary. In this regard, it is conceivable that a positioning pattern which is a marker for positioning of the second FPC 103, is formed at the same time when the wirings and the electrode pads of the first FPC 102 are formed, with reference to a method which is disclosed in JP-A-H11-121894 in that a positioning pattern which is a marker for positioning, is formed at the same time when printing of connecting terminal is performed. According to this arrangement, because there is no need to prepare a new material, it becomes possible to perform easily positioning of the two FPCs 102, 103 with suppressing increase of the production cost.

However, in the case where the two FPCs 102, 103 are bonded, it is necessary to solve below described problem in addition to that positioning can be easily performed. That is, as above described, the first electrode pads 110 are formed in the first FPC 102 in order to connect the two FPCs 102, 103, the first electrode pads 110 are in a state that they are not covered with a protection film and are exposed. As a result, it causes a problem that they can be easily peeled off by heat or stress. Further, it also causes a problem that possibility of breaking of the wirings which are connected to the first electrode pads 110 tends to be higher by a load that is applied to the FPC in relation to the fact that the first electrode pads 110 are not covered with the protection film and are exposed. As a result, in the case where the two FPCs are connected, it is necessary to solve such problems, too, so it is not enough to set up only the positioning pattern as disclosed in JP-A-H11-121894.

### SUMMARY OF THE INVENTION

In view of the above described problems, it is an object of the present invention to provide a flexible print circuit which positioning operation can be easily performed when the electrode pads which are formed in two flexible print circuits are bonded together and peeling off of the electrode pads can be suppressed. Further, it is another object of the present invention to provide a flexible print circuit which positioning operation can be easily performed when the electrode pads which are formed in two flexible print circuits are bonded together and a countermeasure for breaking of the wiring which is connected to the electrode pads, is prepared. In addition, it is other object of the present invention to provide a flexible print circuit for liquid crystal display device which can reduce a load for manufacturing operation and can suppress a production cost by including the above described flexible print circuit.

To attain the above described object a flexible print circuit in accordance with the present invention includes: a base; a plurality of wirings which are formed on the base; a protection film which covers the wirings; and a first electrode pad which is formed on the base to be connected to a prescribed wiring among the plurality of wirings, and which is exposed without being covered with the protection film. The first electrode pad is set up to be bonded with a second electrode pad which is included in other flexible print circuit, a positioning pattern which is made of the same material as the first electrode pad, and which is used as a marker to position the other flexible print circuit when the first electrode pad and the second electrode pad are bonded together, is extended from the first electrode pad.

According to this structure, a positioning pattern to bond other FPC is set up in the flexible print circuit (FPC). According to this arrangement bonding operation for bonding other FPC to the FPC in accordance with the present invention can be easily performed. Further, because the FPC is structured such that the positioning pattern is extended from the electrode pad which is set up to be bonded with other FPC, substantial area where the electrode pad is bonded to the base, is increased and peeling off of the electrode pad can be reduced. Still further, because the positioning pattern is made of the same material as the electrode pad, additional material which is required when the silk printing is utilized, is not need to be prepared, and production cost rising can be suppressed.

Further, it is preferable that at least a part of the positioning pattern is covered with the protection film in the flexible print circuit in accordance with the present invention and structured as above described. According to this arrangement, the positioning pattern becomes hard to peel off from the base, as a result, possibility of peeling off of the electrode pad which is formed in the FPC can be reduced more.

Further, the first electrode pad may be connected to a patterned line at a second position that approximately opposes to a first position at which the prescribed wiring and the first electrode pad are connected, with regard to the first electrode pad, and the positioning pattern may have a portion which is extended from a substantially middle position that is sandwiched between the first position and the second position of the first electrode pad in the flexible print circuit in accordance with the present invention and structured as above described. According to this arrangement, it becomes possible to prevent effectively peeling off of the electrode pad by the prescribed wiring, the patterned line, and the positioning pattern which are connected to the electrode pad, as a result, peeling off of the electrode pad in the flexible print circuit can be reduced.

Further, an auxiliary patterned line which is connected to the prescribed wiring may be drawn out from the positioning pattern in the flexible print circuit in accordance with the present invention and structured as above described. If the electrode pad is exposed without being covered with the protection film, breaking of wire tends to be generated between the prescribed wiring and the electrode pad. In this regard, according to this structure, electrical connection between the prescribed wiring and the electrode pad can be compensated by existence of the auxiliary patterned line even when the breaking of wire is generated between the prescribed wiring and the electrode pad.

Further, bonding of the first electrode pad and the second electrode pad may be performed utilizing solder in the flexible print circuit in accordance with the present invention and structured as above described. Even in such case, two FPCs can be easily positioned to be bonded, also peeling off of the electrode pad can be reduced. In addition, two FPCs can be easily positioned to be bonded, also a countermeasure of breaking of wire can be prepared.

Further, to attain the above described object, the flexible print circuit is provided in a liquid crystal display device in accordance with the present invention and said liquid crystal display is characterized in that it is provided with the flexible print circuit structured as above described. According to this arrangement, in the liquid crystal display device which includes two FPCs that require to be bonded, positioning of the two FPCs can be easily performed, and load for manufacturing operation can be reduced. In addition, because possibility of generation of peeling off of the electrode pad in the FPC can be reduced, reducing of load for manufacturing operation and at the same time, suppressing of production cost can be realized.

The liquid crystal display device which is structured as above described may include, for example : a liquid crystal panel; and a back light source which supplies light to the liquid crystal panel. The wirings which are set up in the flexible print circuit may be wirings to drive the liquid crystal panel and the back light source. The prescribed wiring which is connected to the first electrode pad may be a wiring to drive the back light source. And the other flexible print circuit may be a flexible print circuit which has a wiring to drive the back light source.

As above described, according to the present invention, a flexible print circuit can be provided, which positioning operation can be easily performed when the electrode pads which are formed in these two flexible print circuits are bonded together and peeling off of the electrode pad can be suppressed. Further, according to the present invention, a flexible print circuit can be provided, which positioning operation can be easily performed when the electrode pads which are formed in these two flexible print circuits are bonded together and a countermeasure for breaking of wiring which is connected to the electrode pad, is prepared. In addition, according to the present invention, a liquid crystal display device which can reduce a load for manufacturing operation and can suppress a production cost by including the above described flexible print circuit, can be provided, too.

### BRIEF DESCRIPTION OF THE DRAWINGS

Fig. 1 is a schematic perspective view to show structure of a first embodiment of a liquid crystal display device which is provided with a FPC in accordance with the present invention;
Fig. 2 is a schematic plan view to show structure of a characterized part of a first FPC which is included in the liquid crystal display device according to the first embodiment;
Fig. 3 is a schematic cross sectional view when cut along a line III-III in Fig. 2;
Fig. 4A is a diagram to explain a state where electrode pads of the first FPC and electrode pads of a second FPC are bonded in the liquid crystal display device according to the first embodiment, and to show a state before they are bonded;
Fig. 4B is a diagram to explain a state where electrode pads of the first FPC and electrode pads of a second FPC are bonded in the liquid crystal display device according to the first embodiment, and to show a state after they are bonded;
Fig. 5A is a diagram to show an example of variation of the first FPC which is included in the liquid crystal display device according to the first embodiment;
Fig. 5B is a diagram to show another example of variation of the first FPC which is included in the liquid crystal display device according to the first embodiment;
Fig. 6 is a diagram to explain structure of a first FPC which is included in the liquid crystal display device according to a second embodiment;
Fig. 7 is a diagram to show another embodiment of a liquid crystal display device in accordance with the present invention;
Fig. 8A is a diagram to show structure of a conventional liquid crystal display device and is a schematic plan view of the liquid crystal display device when viewed from a front side;
Fig. 8B is a diagram to show structure of a conventional liquid crystal display device and is a schematic perspective view of the liquid crystal display device when viewed from a back side in an oblique direction;
Fig. 9A is a diagram to explain structure of the two FPCs which are included in the conventional liquid crystal display device, and is a diagram to show circumference of the first electrode pads of the first FPC in which wirings to drive the back light sources and the liquid crystal panel are formed; and
Fig. 9B is a diagram to explain structure of the two FPCs which are included in the conventional liquid crystal display device, and is a diagram to show circumference of a second electrode pads of the second FPC in which wirings to drive the back light sources are formed.

### DETAILED DESCRIPTION OF THE PREFERRED EMBODIMENTS

Hereinafter explanation will be given about embodiments of the present invention with reference to drawings. It should be noted that the embodiments shown here are mere examples and the present invention is not intended to be limited to the embodiments shown here.

### [First Embodiment]

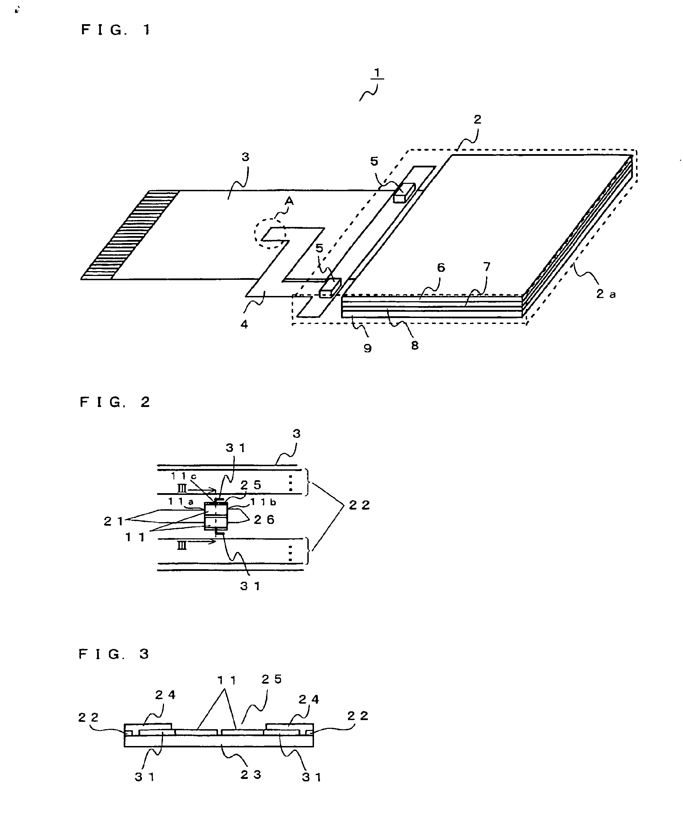

Fig. 1 is a schematic perspective view to show structure of a first embodiment of a liquid crystal display device which is provided with a flexible print circuit (FPC) in accordance with the present invention. Fig. 1 is a diagram when the liquid crystal display device 1 is viewed from reverse surface side (reverse side of a side where a liquid crystal display surface 2a can be seen). The liquid crystal display device 1 according to the first embodiment is provided with a liquid crystal display portion 2, a first FPC 3, and a second FPC 4. In the liquid crystal display portion 2, back light sources 5, a reflection sheet 6, a light guide plate 7, an optical sheet 8, and a liquid crystal panel 9 are included as shown in Fig. 1.

The first FPC 3 has wirings to drive the back light sources 5 and the liquid crystal panel 9 and one ends of these wirings are connected to an external connector which is not shown. Further, the other ends of the wirings to drive the back light sources 5 which are formed in the first FPC 3, are connected to first electrode pads (detail of it will be described later) which are formed in the first FPC 3. On the other hand, the other ends of the wirings to drive the liquid crystal panel 9 which are formed in the first FPC 3, are connected to an electrode which is not shown, of the liquid crystal panel 9.

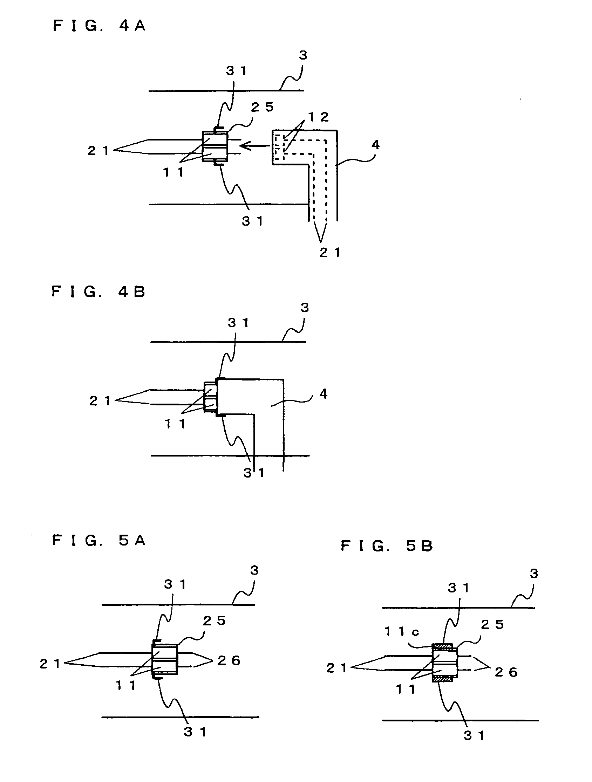

The second FPC 4 has wirings to drive the back light sources 5. One ends of the wirings are connected to the back light sources 5, and the other ends of the wirings are connected to second electrode pads (though they are not shown in Fig. 1, they are shown in Fig. 4A with reference numeral 12) which are set up near a tip of the second FPC 4. Then, by bonding the electrode pads which are formed in the first FPC 3 and the second FPC 4 (the first electrode pads and the second electrode pads) each other, the first FPC 3 and the second FPC 4 are connected electrically.

Structure of the liquid crystal display device 1 according to the first embodiment is similar to that of the conventional liquid crystal display device 100 which is shown in Fig. 8A and Fig. 8B, except structure of the first FPC 3 in a portion where the first FPC 3 and the second FPC 4 are bonded that is shown by a dotted line circle A in Fig. 1. Therefore, detailed explanation will be omitted about portions which have similar structure to the conventional liquid crystal display device 100. Hereinafter, explanation will be given in detail about portions of the first FPC 3 which have different structure from the conventional structure.

Fig. 2 is a schematic plan view to show structure of a characterized part of the first FPC 3 which is included in the liquid crystal display device 1 according to the first embodiment. Further, Fig. 3 is a schematic cross sectional view when cut along a line III-III in Fig. 2. Hereinafter, explanation will be given about structure of the first FPC 3 with reference to these Fig. 2 and Fig. 3.

In the first FPC 3, wirings 21, 22 which are made of, for example, copper or the like, and first electrode pads 11 (two pads as shown in Fig. 2 or Fig. 3) which are made of the same material as the wirings 21, 22 and are connected to the wirings 21, are formed on a base 23 which is made of, for example, polyimide or the like. The wirings 21, 22 are covered with a protection film 24 which is made of, for example, polyimide or the like. However, an opening 25 is set up in the protection film 24, the first electrode pads 11 are made in an exposed state from this opening 25 without being covered with the protection film 24. Because the first electrode pads 11 are made in the exposed state as above described, they can be bonded with electrode pads (they are also exposed) which are formed in the second FPC 4, and these two electrode pads can be connected electrically.

It should be noted that the wirings 21 are wirings to drive the back light sources 5, and the wirings 22 are wirings to drive the liquid crystal panel 9. The wirings 22 are shown only a part of them because the wirings 22 are composed of so many wirings. In the present embodiment, the first electrode pads 11 are made in approximately rectangular shape, however, the present invention is not intended to be limited to the shape, so the electrode pads may be shaped in other shape such as, for example, circular shape, or the like.

On the base 23, patterned lines 26 which are connected to the first electrode pads 11, are formed in positions (second positions 11b) that approximately oppose to positions (first positions 11a) at which the first electrode pads 11 are connected to the wirings 21, with regard to the first electrode pads 11. The patterned lines 26 are set up to reduce peeling off of the first electrode pads 11, and the patterned lines 26 in the present embodiment are mere dummy patterns. Though the patterned lines 26 are mere the dummy patterns which are set up only as a countermeasure for peeling off in the present embodiment, it should be noted that the patterned lines 26 may be structured to function as a part of circuit. Further, though the patterned lines 26 are formed to reduce more effectively peeling off of the first electrode pads 11 as cooperating with the wirings 21 and positioning patterns 31 which will be described in detail later, the patterned lines 26 may not be set up as the case may be.

On the base 23, the positioning patterns 31 (which are made of the same material as the first electrode pads 11) that are extended from the first electrode pads 11, are also formed. The positioning patterns 31 that are extended from the first electrode pads 11, are extended from substantially middle positions 11c which are sandwiched between the first positions 11a and the second positions 11b of the first electrode pads 11. Further, shape of the positioning patterns 31 is made in a shape to match outer shape of the second FPC 4 in order to easily position the second FPC 4. In the present embodiment because the tip side of the second FPC 4 is formed in approximately rectangular shape, the shape of the positioning patterns 31 is formed in approximately L shape pattern to match it. However, two positioning patterns 31 are made in symmetrical shape.

Further, most part of positioning patterns 31 is in a state where it is covered with the protection film 24 except in near side of the first electrode pads 11 where positioning patterns 31 is not covered with the protection film 24. Though a portion of positioning patterns 31 is not covered with the protection film 24 in the present embodiment, it should be noted that all of positioning patterns 31 may be covered with the protection film 24.

As above described, in the first FPC 3 according to the first embodiment, the positioning patterns 31 are extended from the first electrode pads 11. In such case, possibility that the first electrode pads 11 peel off from the base 23, can be reduced because substantial area where the first electrode pads 11 are bonded to the base 23, is increased by the positioning patterns 31. Further in the present embodiment, a part of positioning patterns 31 is covered with the protection film 24, and according to this arrangement, possibility that the positioning patterns 31 peel off from the base 23, is reduced. As a result, possibility that the first electrode pads 11 peel off from the base 23, is further reduced.

That is, the positioning patterns 31 according to the present embodiment carry out a function not only to make perform easily positioning when the second FPC 4 is bonded on the first FPC 3, but also a function to prevent peeling off of the first electrode pads 11.

Next, explanation will be given about a state where the electrode pads on the first FPC 3 and the electrode pads on the second FPC 4 are bonded in the liquid crystal display device 1 according to the present embodiment with reference to Fig. 4A and Fig. 4B. It should be noted that Fig. 4A shows a state before they are bonded, and Fig. 4B shows a state after they are bonded. In Fig. 4A the part shown in dotted line means that it is set up in reverse surface side.

As shown in Fig. 4A, on the second FPC 4 the wirings 21 which drive the back light sources 5, and the second electrode pads 12 which are connected to the wirings 21, are formed. These second electrode pads 12 are bonded with the first electrode pads 11. Because of this, the second electrode pads 12 are set up the same number as the first electrode pads. In the present embodiment the bonding is performed utilizing solder.

In case where the first electrode pads 11 and the second electrode pads 12 are bonded, first, positioning of the second FPC 4 is performed utilizing the positioning patterns 31 as the marker. In the present embodiment the positioning patterns 31 are made to extend from the substantially middle positions 11c which are sandwiched between the first positions 11a and the second positions 11b of the first electrode pads 11, and the second FPC 4 is positioned at the middle positions 11c. That is, approximately half of first electrode pads 11 is exposed without being covered in a state where the second FPC 4 is located.

The solder is located at the exposed portion, then the solder is melted, the solder flows to a portion which is sandwiched by the first electrode pads 11 and the second electrode pads 12, and it becomes possible to bond the first electrode pads 11 and the second electrode pads 12. As above described, in the case where the first electrode pads 11 and the second electrode pads 12 are bonded by the solder, it is preferable that the positioning patterns 31 are set up such that they are extended from the above described substantially middle positions 11c. In the case where the positioning patterns 31 are extended from the above described substantially middle positions 11c, because the positioning patterns 31 cooperate with the wirings 21 and the patterned lines 26 to fix the first electrode pads 11 with three points, it is preferable that effect of preventing the peeling off of the electrode pads becomes larger.

With regard to bonding of the first electrode pads 11 and the second electrode pads 12, the present invention is not intended to be limited to bonding by the solder. That is, the present invention can be, of course, applied to a case or the like where the first electrode pads 11 and the second electrode pads 12 are bonded utilizing an anisotropic conductive film (ACF), for example.

However, when the first electrode pads 11 and the second electrode pads 12 are bonded, there is possibility that they are bonded such that the second electrode pads 12 covers all of the first electrode pads 11. In the case where the bonding is performed without utilizing the solder, it is conceivable that such structure is especially employed. Even in such case, the positioning patterns 31 which are shown in Fig. 5A, may be formed. However, in the case where the structure shown in Fig. 5A is employed, because the positioning patterns 31 are formed at end portion side of the first electrode pads 11, above described effect of the three points fixing cannot be obtained enough and there is possibility that preventing function by the positioning patterns 31 for peeling off of the first electrode pads 11 becomes low. Even in such case, because the positioning patterns 31 are extended from the first electrode pads 11, it should be noted that all prevention function for peeling off of the electrode pads is not missed.

As a result, it is preferable that positioning patterns 31 have portions that are extended from the above described substantially middle positions 11c, for example, rectangular regions which are extended from the first electrode pads 11 as shown in Fig. 5B, if the first electrode pads 11 and the second electrode pads 12 are bonded such that the second electrode pads 12 cover all of the first electrode pads 11. According to this arrangement, the positioning effect and the reducing effect for peeling off of the electrode pads by the positioning patterns 31, can be more effectively achieved.

### [Second Embodiment]

Next, explanation will be given about a second embodiment of a flexible print circuit in accordance with the present invention. In this embodiment, too, explanation will be given about a flexible print circuit (FPC) which is included in the liquid crystal display device by way of example as well as the first embodiment. Structure of the liquid crystal display device 1 according to the second embodiment is similar to that of the first embodiment except structure of the first FPC 3, therefore, explanation will be omitted for the same portions as the first embodiment. Further, in the explanation, same reference numeral will be given to the same portions as the first embodiment.

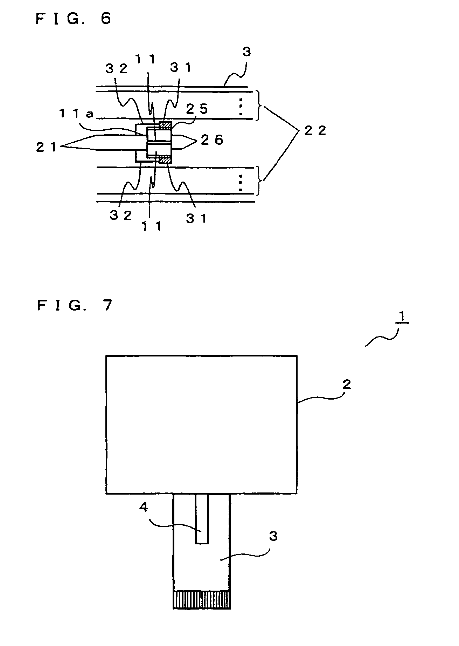

Fig. 6 is a diagram to explain structure of the first FPC 3 which is included in the liquid crystal display device 1 according to the second embodiment. In the first FPC 3 according to the second embodiment, wirings 21, 22 which are made of, for example, copper or the like, and first electrode pads 11 (two pads as shown in Fig. 6) which are made of the same material as the wirings 21, 22 and are connected to the wirings 21, are formed on a base 23 which is made of, for example, polyimide.

It should be noted that, as well as the first embodiment, the wirings 21, 22 are covered with a protection film 24 (See, Fig. 3) which is made of, for example, polyimide. An opening 25 is set up in the protection film 24, the first electrode pads 11 are made in an exposed state from this opening 25 without being covered with the protection film 24. Further, as well as the first embodiment, the wirings 21 are wirings to drive the back light sources 5, and the wirings 22 are wirings to drive the liquid crystal panel 9. The wirings 22 are shown only a part of them because the wirings 22 are composed of so many wirings.

Further on the base 23, as well as the first embodiment, patterned lines 26 which are connected to the first electrode pads 11, are formed. The patterned lines 26 are set up to reduce peeling off of the first electrode pads 11, and the patterned lines 26 in the present embodiment are mere dummy patterns.

On the base 23, positioning patterns 31 that are extended from the first electrode pads 11 and have a rectangular shape, are also formed. It should be noted that, even in the second embodiment, it is assumed that bonding of the first electrode pads 11 and the second electrode pads 12 (See, Fig. 4) is performed utilizing the solder, too, and the pattern shape of the positioning patterns 31 is decided such that the second FPC4 is positioned to cover approximately half of the first electrode pads 11. However, because of reason which will be described later, the positioning pattern 31 are formed in a different shape from that of the first embodiment (See, Fig. 2), that is, L shape in the first embodiment, and a rectangular shape in the present embodiment.

Further, most part of positioning patterns 31 is in a state where it is covered with the protection film 24 except in near side of the first electrode pads 11 where positioning patterns 31 is not covered with the protection film 24 (though it is not shown in Fig. 6, because it has the same structure as that of the first embodiment, see Fig. 3). That is, as well as the first embodiment, in the first FPC 3, because the positioning patterns 31 are extended from the first electrode pads 11, and substantial area where the first electrode pads 11 are bonded to the base 23, is increased by the positioning patterns 31, possibility that the first electrode pads 11 peel off from the base 23, can be reduced. Further, because the positioning patterns 31 are covered with the protection film 24, possibility that the positioning patterns 31 peel off from the base 23, is reduced. As a result, possibility that the first electrode pads 11 peel off from the base 23, is reduced.

In addition to the above described effect, the first FPC 3 according to the second embodiment is characterized by that it is structured such that it can compensate electrical connection between the wirings 21 and the first electrode pads 11 even if breaking of wire is generated at a portion where the first electrode pads 11 and the wirings 21 are connected (at this portion large load tends to be easily applied and breaking of wire can be easily generated). That is, in the present embodiment, auxiliary patterned lines 32 are drawn out from the portions where the rectangular shaped positioning patterns 31 are covered with the protection film 24 (the portions correspond to portions where the positioning patterns 31 are not exposed from the opening 25 in Fig. 6) and the auxiliary patterned line 32 are connected to the wirings 21. It should be noted that the auxiliary patterned lines 32 are in a state that all of the auxiliary patterned lines 32 are covered with the protection film 24 and there is no exposed portion.

According to these arrangement, the electrical connection between the wirings 21 and the first electrode pads 11 can be compensated even if breaking of wire is generated at the first positions 11a where the first electrode pads 11 and the wirings 21 are connected. Further, because all of the auxiliary patterned lines 32 are covered with the protection film 24 (that is, the auxiliary patterned lines 32 are covered even at the portion where they are connected to the positioning patterns 31), possibility of breaking of wire is low. Still further, in the present embodiment, the positioning patterns 31 are made in the rectangular shape, and the region at which it is connected to the first electrode pads 11, is made larger than the case of first embodiment (in the case the positioning patterns 31 are L shaped). As a result, possibility of breaking of wire can be reduced even in portions where large load tends to be applied such as the portion where the positioning patterns 31 are connected to the first electrode pads 11, or the like.

### [Others]

Shape of the two FPCs 3, 4 which are included in the liquid crystal display device 1, is not intended to be limited to shapes which are shown in the first and the second embodiments. Various modifications can be introduced within range where it does not deviate from the object of the present invention. That is, for example, the shape of the two FPCs may be structured as shown in Fig. 7. Further, explanations are given about cases where the two FPCs are bonded for the liquid crystal display device as the example in the first and the second embodiments. However, the FPC in accordance with the present invention can be applied widely to any case where two FPCs are bonded, and needless to say, the present invention can be widely applied to any case that is not limited to the liquid crystal display device.

When the flexible print circuit in accordance with the present invention is used, positioning operation can be easily performed when electrode pads which are formed in one flexible print circuit are bonded to electrode pads which are formed in the other flexible print circuit, and peeling off of the electrode pads can be suppressed. As a result the present invention is useful when two flexible print circuits are bonded.

Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description, but limited only by the features as defined in the appended claims.

## Claims

1. A flexible print circuit, comprising:
a base (23);
a plurality of wirings (21, 22) which are formed on the base;
a protection film (24) which covers the wirings;
a first electrode pad (11) which is formed on the base to be connected to a prescribed wiring among the plurality of wirings, and which is exposed without being covered with the protection film, wherein the first electrode pad is set up to be bonded with a second electrode pad (12) which is included in another flexible print circuit (4); and
a positioning pattern (31), which is used as a marker to position the other flexible print circuit when the first electrode pad (11) and the second electrode pad (12) are bonded,
the positioning pattern (31) is made of the same material as the first electrode pad (11) and is extended from the first electrode pad (11),
**characterized in that** at least a part of the positioning pattern (31) is covered with the protection film (24).

2. The flexible print circuit according to claim 1, **characterized in that**
the first electrode pad is connected to a patterned line at a second position that approximately opposes to a first position at which the prescribed wiring and the first electrode pad are connected, with regard to the first electrode pad, and
the positioning pattern has a portion which is extended from a substantially middle position that is sandwiched between the first position and the second position of the first electrode pad.

3. The flexible print circuit according to any one of claim 1 to claim 2, **characterized in that** an auxiliary patterned line which is connected to the prescribed wiring is drawn out from the positioning pattern.

4. The flexible print circuit according to any one of claim 1 to claim 3, **characterized in that** bonding of the first electrode pad and the second electrode pad is performed utilizing solder.

5. The flexible print circuit according to anyone of claims 1-4 wherein
said circuit is provided for connecting a liquid crystal display device.

6. The flexible print circuit according to claim 5 wherein said liquid crystal display device, further comprising:
a liquid crystal panel; and
a back light source which supplies light to the liquid crystal panel, **characterized in that**
the wirings which are set up in the flexible print circuit are wirings to drive the liquid crystal panel and the back light source,
the prescribed wiring which is connected to the first electrode pad is a wiring to drive the back light source, and
the other flexible print circuit is a flexible print circuit which has a wiring to drive the back light source.

## Patentansprüche

1. Flexibler, gedruckter Schaltkreis, umfassend:
eine Basis (23);
eine Vielzahl von Verdrahtungen (21, 22), die auf der Basis ausgebildet sind;
einen Schutzfilm (24), welcher die Verdrahtungen bedeckt;
eine erste Elektrodenplatte (11), die auf der Basis ausgebildet ist,
um mit einer vorgegebenen Verdrahtung aus der Vielzahl von Verdrahtungen verbunden zu sein und welche frei liegt, ohne von dem Schutzfilm bedeckt zu sein, wobei die erste Elektrodenplatte dazu ausgelegt ist, mit einer zweiten Elektrodenplatte (12) verbunden zu sein, die in einem anderen flexiblen, gedruckten Schaltkreis (4) enthalten ist; und
ein Positionierungsmuster (31), welches als Markierung zum Positionieren des anderen flexiblen, gedruckten Schaltkreises verwendet wird, wenn die erste Elektrodenplatte (11) und die zweite Elektrodenplatte (12) miteinander verbunden werden, wobei das Positionierungsmuster (31) aus dem gleichen Material wie die erste Elektrodenplatte (11) gemacht ist sich von der ersten Elektrodenplatte (11) ausdehnt, **dadurch gekennzeichnet, dass** wenigstens ein Teil des Positionierungsmusters (31) mit dem Schutzfilm (24) bedeckt ist.

2. Flexibler, gedruckter Schaltkreis nach Anspruch 1, **dadurch gekennzeichnet, dass**
die erste Elektrodenplatte in einer zweiten Position mit einer gemusterten Linie verbunden ist, die bezogen auf die erste Elektrodenplatte im Wesentlichen gegenüber einer ersten Position liegt, in welcher die vorgegebene Verdrahtung und die erste Elektrodenplatte angeschlossen sind, und
das Positionierungsmuster einen Bereich hat, der sich von einer im Wesentlichen mittleren Position, die sandwichartig zwischen der ersten Position und der zweiten Position der ersten Elektrodenplatte angeordnet ist, erstreckt.

3. Flexibler, gedruckter Schaltkreis nach einem der Ansprüche 1 bis 2, **dadurch gekennzeichnet, dass** eine gemusterte Hilfslinie, die mit der vorgegebenen Verdrahtung verbunden ist, aus dem Positionierungsmuster herausgezogen ist.

4. Flexibler, gedruckter Schaltkreis nach einem der Ansprüche 1 bis 3, **dadurch gekennzeichnet, dass** die erste Elektrodenplatte und die zweite Elektrodenplatte mit Lötmittel miteinander verbunden sind.

5. Flexibler, gedruckter Schaltkreis nach einem der Ansprüche 1 bis 4, wobei der Schaltkreis zum Anschließen einer Flüssigkristall-Displayvorrichtung vorgesehen ist.

6. Flexibler, gedruckter Schaltkreis nach Anspruch 5, wobei die Flüssigkristall-Displayvorrichtung ferner umfasst:
ein Flüssigkristall-Panel; und
eine Hintergrundbeleuchtungsquelle, die Licht für das Flüssigkristall-Panel bereitstellt, **dadurch gekennzeichnet, dass** die Verdrahtungen, die in den flexiblen, gedruckten Schaltkreis eingearbeitet sind, Verdrahtungen zum Antreiben des Flüssigkristall-Panels und
der Hintergrundbeleuchtungsquelle sind,
die vorgegebene Verdrahtung, die mit der ersten Elektrodenplatte verbunden ist, eine Verdrahtung zum Betreiben der Hintergrundbeleuchtungsquelle ist, und
der flexible, gedruckte Schaltkreis ein flexibler gedruckter Schaltkreis ist, der eine Verdrahtung zum Betreiben der Hintergrundbeleuchtungsquelle umfasst.

## Revendications

1. Circuit imprimé souple, comprenant :
un support (23) ;
une pluralité de câblages (21, 22) qui sont formés sur le support ;
un film de protection (24) qui recouvre les câblages ;
une première électrode (11) qui est formée sur le support et doit être reliée à un câblage déterminé au préalable parmi la pluralité de câblages, et qui est exposée sans être recouverte par le film de protection, la première électrode étant installée de manière à être reliée à une seconde électrode (12) qui est incluse dans un autre circuit imprimé souple (4) ; et
un motif de positionnement (31), qui est utilisé comme marqueur pour positionner l'autre circuit imprimé souple quand la première électrode (11) et la seconde électrode (12) sont reliées,
le motif de positionnement (31) étant constitué du même matériau que la première électrode (11) et s'étendant à partir de la première électrode (11),
**caractérisé en ce que**
au moins une partie du motif de positionnement (31) est recouverte par le film de protection (24).

2. Le circuit imprimé souple selon la revendication 1, **caractérisé en ce que**
la première électrode est connectée à une ligne à motif dans une seconde position qui est à peu près opposée à une première position dans laquelle le câblage déterminé au préalable et la première électrode sont connectés, et
le motif de positionnement possède une portion qui s'étend à partir d'une position sensiblement médiane qui est prise en sandwich entre la première position et la seconde position de la première électrode.

3. Le circuit imprimé souple selon l'une quelconque des revendications 1 à 2, **caractérisé en ce qu'**une ligne à motif auxiliaire qui est connectée au câblage déterminé au préalable sort du motif de positionnement.

4. Le circuit imprimé souple selon l'une quelconque des revendications 1 à 3, **caractérisé en ce que** la connexion entre la première électrode et la seconde électrode est réalisée en utilisant une soudure.

5. Le circuit imprimé souple selon l'une quelconque des revendications 1 à 4, dans lequel ledit circuit est prévu pour la connexion d'un dispositif d'affichage à cristaux liquides.

6. Le circuit imprimé souple selon la revendication 5, dans lequel ledit dispositif d'affichage à cristaux liquides comprend en outre:
un panneau à cristaux liquides ; et
une source de rétroéclairage qui fournit de la lumière au panneau à cristaux liquides, **caractérisé en ce que**
les câblages qui sont installés dans le circuit imprimé souple sont des câblages permettant de commander le panneau à cristaux liquides et la source de rétroéclairage,
le câblage déterminé au préalable qui est connecté à la première électrode est un câblage permettant de commander la source de rétroéclairage, et
l'autre circuit imprimé souple est un circuit imprimé souple qui possède un câblage permettant de commander la source de rétroéclairage.
